Europäisches Patentamt

(19) European Patent Office

Office européen des brevets

(11) **EP 1 178 356 B1**

(12) **EUROPÄISCHE PATENTSCHRIFT**

(45) Veröffentlichungstag und Bekanntmachung des Hinweises auf die Patenterteilung:
**22.09.2004 Patentblatt 2004/39**

(51) Int Cl.$^7$: **G03F 7/20**, G02B 17/06

(21) Anmeldenummer: **01116916.6**

(22) Anmeldetag: **11.07.2001**

(54) **6-Spiegel-Mikrolithographie-Projektionsobjektiv**

6 mirror microlithography projection system

Système de projection à six miroirs pour la microlithographie

(84) Benannte Vertragsstaaten:
**DE FR GB IE NL**

(30) Priorität: **01.08.2000 DE 10037870**

(43) Veröffentlichungstag der Anmeldung:
**06.02.2002 Patentblatt 2002/06**

(73) Patentinhaber: **Carl Zeiss SMT AG**
**73447 Oberkochen (DE)**

(72) Erfinder:
• **Mann, Hans-Jürgen, Dr.**
**73447 Oberkochen (DE)**
• **Dinger, Udo, Dr.**
**73447 Oberkochen (DE)**

• **Mühlbeyer, Michael**
**73430 Aalen (DE)**

(74) Vertreter: **Dr. Weitzel & Partner**
**Friedenstrasse 10**
**89522 Heidenheim (DE)**

(56) Entgegenhaltungen:
**EP-A- 1 035 445**

• **PATENT ABSTRACTS OF JAPAN vol. 2000, no. 07, 29. September 2000 (2000-09-29) -& JP 2000 100694 A (NIKON CORP), 7. April 2000 (2000-04-07) -& US 6 172 825 B1 (NIKON CORP) 9. Januar 2001 (2001-01-09)**

**Beschreibung**

Die Erfindung betrifft ein Mikrolithographieobjektiv gemäß dem Oberbegriff von Anspruch 1, eine Projektionsbelichtungsanlage gemäß Anspruch 21 sowie ein Chipherstellungsverfahren gemäß Anspruch 22.

Die Lithographie mit Wellenlängen < 193 nm, insbesondere die EUV-Lithographie mit $\lambda$ = 11 nm bzw. $\lambda$ = 13 nm werden als mögliche Techniken zur Abbildungen von Strukturen < 130 nm, besonders bevorzugt < 100 nm diskutiert. Die Auflösung eines lithographischen Systems wird durch nachfolgende Gleichung beschrieben:

$$RES = k_1 \cdot \frac{\lambda}{NA}$$

wobei k1 ein spezifischer Parameter des Lithographieprozesses, $\lambda$ die Wellenlänge des einfallenden Lichtes und NA die bildseitige, numerische Apertur des Systems bezeichnet.

Für abbildende Systeme im EUV-Bereich stehen als optische Komponenten im wesentlichen reflektive Systeme mit Multilayer-Schichten zur Verfügung. Als Multilayer-Schichtsysteme finden bei $\lambda$ = 11 nm bevorzugt Mo/Be-Systeme und bei $\lambda$ = 13 nm Mo/Si-Systeme Verwendung.

Legt man eine numerische Apertur von 0,2 zugrunde, so erfordert die Abbildung von 50 nm-Strukturen mit 13 nm-Strahlung einen vergleichsweise einfachen Prozeß mit $k_1$ = 0,77. Mit $k_1$ = 0,64 wird bei 11 nm-Strahlung die Abbildung von 35 nm-Strukturen möglich.

Da die Reflektivität der eingesetzten Multilayer-Schichten nur im Bereich von ungefähr 70 % liegt, ist es bei den Projektionsobjektiven für die EUV-Mikrolithographie von ganz entscheidender Bedeutung, zum Erreichen einer ausreichenden Lichtstärke mit möglichst wenig optischen Komponenten im EUV-Projektionsobjektiv auszukommen.

Als besonders bevorzugt haben sich mit Blick auf eine hohe Lichtintensität und ausreichende Möglichkeiten zur Korrektur von Abbildungsfehlern bei NA = 0,20 Systeme mit sechs Spiegeln herausgestellt.

6-Spiegel-Systeme für die Mikrolithographie sind aus den Druckschriften US-A-5 153 898, EP-A-0 252 734, EP-A-0 947 882, US-A-5686728, EP 0 779 528, US 5 815 310, WO 99/57606 und US 6 033 079 bekannt geworden.

Das Projektions-Lithographiesystem gemäß der US-A-5 686 728 zeigt ein Projektionsobjektiv mit sechs Spiegeln, wobei jede der reflektiven Spiegelflächen asphärisch ausgebildet ist. Die Spiegel sind entlang einer gemeinsamen optischen Achse so angeordnet, daß ein obskurationfreier Lichtweg erreicht wird.

Da das aus der US-A-5 686 728 bekannte Projektionsobjektiv nur für UV-Licht mit einer Wellenlänge von 100 - 300 nm eingesetzt wird, weisen die Spiegel dieses Projektionsobjektives eine sehr hohe Asphärizität von ungefähr +/- 50 µm sowie sehr große Einfallswinkel von ca. 38° auf. Auch nach Abblenden auf NA = 0,2 verbleibt hier eine Asphärizität von 25 µm von Spitze zu Spitze bei kaum vermindertem Einfallswinkel. Derartige Asphärizitäten und Einfallwinkel sind im EUV-Bereich wegen der hohen Anforderungen an die Oberflächenqualität, Reflektivität der Spiegel nicht praktikabel.

Ein weiterer Nachteil des aus der US-A-5 686 728 bekannt gewordenen Objektives, der einen Einsatz im Bereich von $\lambda$ < 100 nm, insbesondere bei den Wellenlängen von 11 und 13 nm nicht mehr erlaubt, ist der sehr geringe Abstand zwischen dem Wafer und dem dem Wafer am nächsten liegenden Spiegel. Bei den aus der US-A-5 686 728 bekanntgewordenen Abständen von Wafer und wäfernächstem Spiegel können die Spiegel nur sehr dünn ausgebildet werden. Wegen der extremen Schicht-Spannungen in den Multilayer-Systemen für die angesprochenen Wellenlängen von 11 und 13 nm sind derartige Spiegel sehr instabil.

Aus der EP-A-0 779 528 ist ein Projektionsobjektiv mit sechs Spiegeln zum Einsatz in der EUV-Lithographie, insbesondere auch bei Wellenlängen von 13 nm und 11 nm, bekanntgeworden.

Auch dieses Projektionsobjektiv hat den Nachteil, daß mindestens zwei der insgesamt sechs Spiegel sehr hohe Asphärizitäten von 26 bzw. 18,5 µm aufweisen. Insbesondere ist aber auch bei der aus der EP-A-0779528 bekannten Anordnung der optische freie Arbeitsabstand zwischen wafernächstem Spiegel und Wafer derart gering, daß es entweder zu Instabilitäten oder aber einem mechanisch freien Arbeitsabstand, der negativ ist, kommt.

Aus der WO 99/57606 ist ein 6-Spiegel-Projektionsobjektiv für die EUV-Lithographie mit einer Spiegelabfolge konkav - konkav - konvex - konkav - konvex - konkav gezeigt, das eine numerische Apertur am Objekt $NA_{Objekt}$ = 0,2 aufweist. Alle Spiegel des aus der WO 99/57606 bekannten Systems sind asphärisch ausgebildet.

Nachteilig an dem aus der WO 99/57606 bekannten 6-Spiegel-Objektiv ist, daß eine leichte Zugänglichkeit der Nutzbereiche beispielsweise für eine Einfassung insbesondere am zweiten und dritten Spiegel nicht gegeben ist. Desweiteren ist der Nutzbereich des vierten Spiegels bei dem aus der WO 99/57606 bekannten System weit außerhalb der optischen Achse angeordnet. Dies führt zu Problemen in bezug auf die Stabilität des Spiegelsystems und bei der Herstellung dieses Spiegelsegmentes. Auch wird ein großer umbauter Raum benötigt, um das System zu kapseln. Da das System im Vakuum eingesetzt wird, ist ein relativ großer Raum zu evakuieren.. Die gemäß der WO99/57606 zwischen dem zweiten und dem dritten Spiegel angeordnete Blende hat große Inzidenzwinkel auf dem dritten Spiegel zur Folge, die insbesondere größer als 18° sind.

Aus der US 6033079 ist ein 6-Spiegel-System bekannt, bei dem die Inzidenzwinkel auf allen Spiegeln kleiner als 18° sind. Allerdings hat auch dieses System den Nachteil, daß der Nutzbereich des dritten Spiegels nicht zugänglich ist und die Nutzbereiche einzelner Spiegel, beispielsweise des vierten Spiegels (M4) so groß sind, daß wie bei dem aus der WO 99/57606 bekannten System ein großer umbauter Raum benötigt wird, was wiederum einen relativ großen zu evakuiierenden Raum zur Folge hat. Ein weiterer Nachteil von relativ großen Spiegeln ist deren mangelnde Stabilität und die Tatsache, daß entsprechend große Beschichtungskammem und Fertigungsmaschinen für deren Herstellung benötigt werden.

Aufgabe der Erfindung ist es somit, eine für die Lithographie mit kurzen Wellenlängen, vorzugsweise kleiner 100 nm, geeignetes Projektionsobjektiv anzugeben, das die zuvor erwähnten Nachteile des Standes der Technik nicht aufweist, insbesondere soll ein Projektionsobjektiv angegeben werden, das sich durch möglichst geringe Abmessungen, eine gute Zugänglichkeit des Nutzbereiches eines jeden Spiegels auszeichnet sowie eine möglichst große Apertur und möglichst große Korrektionsmöglichkeiten betreffend Abbildungsfehler aufweist.

Erfindungsgemäß wird diese Aufgabe durch ein Mikrolithographie-Projektionsobjektiv für kurze Wellenlängen, vorzugsweise ≤ 193 nm gelöst, das eine Eintrittspupille und eine Austrittspupille zur Abbildung eines Objektfeldes in ein Bildfeld, das das Segment eines Ringfeldes darstellt, umfasst, wobei das Segment eine Symmetrieachse und eine Ausdehnung senkrecht zur Symmetrieachse aufweist und die Ausdehnung mindestens 20, bevorzugt 25 mm ist sowie einen ersten, einen zweiten, einen dritten, einen vierten, einen fünften und einen sechsten Spiegel in zentrierter Anordnung zu einer optischen Achse umfasst, wobei jeder dieser Spiegel einen Nutzbereich aufweist, in dem die Lichtstrahlen, die durch das Projektionsobjektiv geführt werden, auftreffen und der Durchmesser des Nutzbereiches des ersten, zweiten, dritten, vierten, fünften und sechsten Spiegels in Abhängigkeit von der numerischen Apertur NA an der Austrittspupille ≤ 1200mm*NA ist, bevorzugt ≤ 300 mm, wobei die numerische Apertur NA an der Austrittspupille des erfindungsgemäßen Objektivs ist größer als 0,1, bevorzugt größer als 0,2, besonders bevorzugt größer als 0,23. Unter numerischer Apertur an der Austrittspupille wird in vorliegender Anmeldung die numerische Apertur des auf die Bildebene auftreffenden Strahlbüschels verstanden, die sogenannte bildseitige numerische Apertur.

Im Bereich der Mikrolithographie ist es vorteilhaft, wenn das abbildende Strahlbündel telezentrisch auf die Bildebene trifft. Vorteilhafterweise ist dann der sechste Spiegel des Projektionsobjektives S6 konkav geformt. Der fünfte Spiegel S5 liegt zwischen dem sechsten Spiegel S6 und der Bildebene.

Will man bei einem derartigen Objektiv einen abschattungsfreien Strahlengang realisieren, so wirkt sich dies auf die numerische Apertur NA an der Austrittspupille aus.

In einer vorteilhaften Ausführungsform wird ein abschattungsfreier Strahlengang im Objektiv dadurch realisiert, daß mit steigender numerischer Apertur an der Austrittspupille auch der mittlere Radius des abzubildenden Ringfeldes wächst.

Die Zugänglichkeit der einzelnen Spiegel des Objektives, insbesondere zum Zwecke der Einfassung der Spiegel wird in einer fortgebildeten Ausführungsform gewährleistet, wenn der erste, zweite, dritte, vierte, fünfte und sechste Spiegel jeweils einen rückwärtigen Bauraum aufweist, der entlang der optischen Achse gemessen von der Spiegelvorderseite im Nutzbereich eine Tiefe aufweist, wobei die Tiefe jeweils des ersten, zweiten, dritten, vierten und sechsten Bauraumes mindestens 50 mm und die Tiefe des Bauraumes des fünften Spiegels größer als 1/3 des Wertes des Durchmessers des fünften Spiegels ist und sich die jeweilgen Bauräume nicht durchdringen.

Besonders vorteilhaft mit Blick auf die Zugänglichkeit ist es, wenn alle Bauräume in eine Richtung parallel zur Symmetrieachse ausdehnbar sind, ohne daß der Lichtweg im Objektiv oder der Bauraum eines anderen Spiegels geschnitten wird.

Ein besonders stabiles System im Hinblick auf die schichtspannungsinduzierten Randdeformationen erhält man, wenn der Randbereich umlaufend um den Nutzbereich aller Spiegel mehr als 4 mm beträgt, wobei die Lichtführung im Objektiv obskurationsfrei erfolgt.

Die Beschichtung der Spiegelsubstrate mit den zuvor erwähnten Mo/Be oder Mo/Si-Vielfachschichtsystemen haben oftmals Spannungen zur Folge, die besonders am Rand des Substrates zu Deformationen führen können. Ein ausreichend großer Randbereich verhindert, daß diese sich in den Nutzbereich des Spiegels fortsetzen.

In einer bevorzugten Ausführungsform liegt der Nutzbereich des vierten Spiegels geometrisch zwischen zweitem Spiegel und der Bildebene.

Besonders bevorzugt ist es, wenn der vierte Spiegel geometrisch zwischen drittem und zweitem Spiegel, insbesondere zwischen erstem und zweitem Spiegel angeordnet ist. Eine derartige Anordnung hat besonders geringe Abmessungen der Nutzbereiche des ersten, zweiten, dritten und vierten Spiegels zur Folge.

Der Abstand der Spiegelscheitel entlang der optischen Achse von viertem und erstem Spiegel (S4 S1) zum Abstand von zweitem und erstem Spiegel (S2 S1) liegt vorteilhafterweise im Bereich

$$0,1 < \frac{(S4\ S1)}{(S2\ S1)} < 0,9$$

und der Abstand von drittem und zweitem Spiegel (S2 S3) zum Abstand von viertem zu drittem Spiegel (S4 S3) im Bereich

$$0,3 < \frac{(S3\ S4)}{(S2\ S3)} < 0,9$$

Um einen abschattungsfreien Strahlengang zu erreichen, gibt es insbesondere im Objektivteil umfassend den fünften und den sechsten Spiegel zwei kritische Bereiche.

Der eine Bereich liegt am oberen Rand des fünften Spiegels. Die Strahlführung muß dort so erfolgen, daß die unteren Randstrahlen oberhalb des Nutzbereiches dieses Spiegels verlaufen und auf die Bildebene auftreffen. Der andere Bereich liegt am unteren Rand des sechsten Spiegels.

Ein abschattungsfreier Strahlverlauf wird in den oben genannten Bereichen am fünften und sechsten Spiegel in paraxialer Näherung erreicht, wenn der mittlere Ringfeldradius in Abhängigkeit von der numerischen Apertur NA an der Austrittspupille, den Abständen der Spiegelscheitel von fünftem und sechsten Spiegel (S5 S6), den Abstand von fünftem Spiegel und Bildebene (S5B), dem Krümmungsradius $r_5$, $r_6$ des fünften bzw. sechsten Spiegels zu

$$R \geq \tan\ (\ \text{arc}\ \ \sin\ \ (\ \textit{NA})\ )\ *$$

$$\left[\ (\ S5\ B\ )\ +\ (\ S5\ S6\ )\ -\ \cfrac{1}{\cfrac{2}{r_6}\ -\ \cfrac{1}{r_5\ +\ (\ S5\ S6\ )}}\ \right]$$

gewählt wird. Ein Unterschreiten des Mindestradius führt bei Beibehalten der Bedingung eines obskurationsfreien Strahlverlaufes zu einem sprunghaften Anstieg der asphärischen Abweichung von der sphärischen Grundform der Spiegel, die auch als Asphärizität der Spiegel bezeichnet wird. Dies gilt insbesondere für den fünften Spiegel. Damit wird der Bereich, für den die paraxiale Näherung und die zuvor genannte Formel gilt, verlassen. Spiegel mit hoher Asphärizität sind aber fertigungstechnisch nur mit hohem Aufwand herzustellen.

Um die Winkelbelastung auf den Spiegeln gering zu halten, ist vorteilhafterweise vorgesehen, daß der Einfallswinkel des Hauptstrahles des Feldpunktes, der auf der Symmetrieachse in der Mitte des Objektfeldes liegt, auf allen Spiegel < 18° ist.

In einer besonderen Ausführungsform der Erfindung weist das Projektionsobjektiv ein Zwischenbild auf, wobei das Zwischenbild vorteilhafterweise im Projektionsobjektiv in der Lichtrichtung nach dem vierten Spiegel ausgebildet wird.

In einer ersten Ausgestaltung der Erfindung ist der erste Spiegel konvex und alle sechs Spiegel sind asphärisch ausgebildet.

In einer weiteren Ausgestaltung der Erfindung ist der erste Spiegel konkav und alle sechs Spiegel asphärisch ausgebildet.

Alternativ hierzu kann der erste Spiegel paraxial plan und alle sechs Spiegel asphärisch ausgebildet sein.

Eine gegenüber einer Ausgestaltung der Erfindung, bei der alle Spiegel asphärisch ausgebildet sind, besonders einfache Fertigbarkeit ergibt sich, wenn höchstens fünf Spiegel asphärisch sind.

Besonders bevorzugt ist es, wenn der Spiegel mit dem von der optischen Achse am entferntesten liegenden Nutzbereich, das ist in der Regel der vierte Spiegel, sphärisch ausgebildet ist.

Neben dem Projektionsobjektiv stellt die Erfindung auch eine Projektionsbelichtungsanlage zur Verfügung, wobei die Projektionsbelichtungsanlage eine Beleuchtungseinrichtung zur Beleuchtung eines Ringfeldes sowie ein Projektionsobjektiv gemäß der Erfindung umfasst.

Die Erfindung soll nachfolgend anhand der Ausführungsbeispiele beschrieben werden.

Es zeigen:

Figur 1:     den Nutzbereich eines Spiegels

Figur 2:     das Ringfeld in der Objektebene des Objektives

Figur 3:     die Definiton des Bauraumes für zwei beliebige Spiegel des Projektionsobjektives

Figur 4:     eine erste Ausführungsform eines erfindungsgemäßen Projektionsobjektives mit sechs asphärischen Spiegeln, wobei der erste Spiegel konvex ausgebildet ist

Figur 5:   eine zweite Ausführungsform eines erfindungsgemäßen Projektionsobjektives mit sechs asphärischen Spiegeln, wobei der erste Spiegel konkav ausgebildet ist

Figuren 6a-6f   der Nutzbereich sämtlicher sechs Spiegel eine Projektionsobjektives gemäß Figur 4

Figur 7:   eine dritte Ausführungsform eines erfindungsgemäßen Projektionsobjektives mit sechs asphärischen Spiegeln, wobei der erste Spiegel paraxial plan ausgebildet ist

Figur 8:   eine vierte Ausführungsform eines erfindungsgemäßen Projektionsobjektives mit fünf asphärischen und einem sphärischen Spiegel, wobei der vierte Spiegel sphärisch ausgebildet ist

Figur 9:   Bereich des fünften und sechsten Spiegels eines Sechs-Spiegel-Projektionsobjektives gemäß der Erfindung

Figur 10:   der prinzipielle Aufbau einer Projektionsbelichtungsanlage mit einem erfindungsgemäßen Objektiv

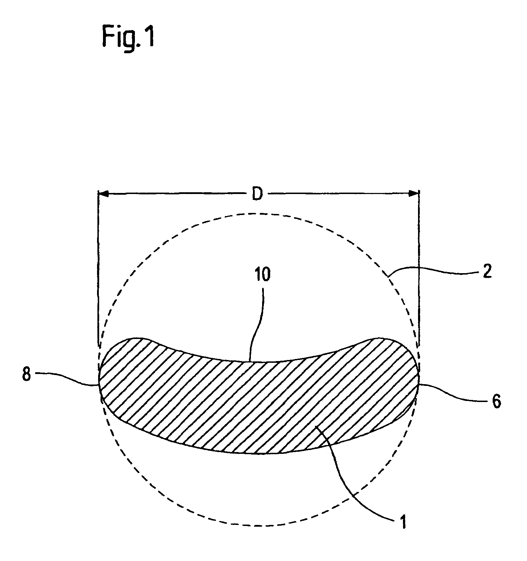

In Figur 1 ist dargestellt, was in der vorliegenden Anmeldung unter Nutzbereich und Durchmesser des Nutzbereiches zu verstehen ist.

Figur 1 zeigt beispielhaft für ein ausgeleuchtetes Feld 1 auf einem Spiegel des Projektionsobjektives ein Feld in Nierenform. Eine derartige Form wird für den Nutzbereich bei Verwendung des erfindungsgemäßen Objektive in einer Mikrolithographie-Projektionsbelichtungsanlage erwartet. Der Hüllkreis 2 umschließt die Nierenform völlig und fällt an zwei Punkten 6, 8 mit dem Rand 10 der Nierenform zusammen. Der Hüllkreis ist stets der kleinste Kreis, der den Nutzbereich umfasst. Der Durchmesser D des Nutzbereiches ergibt sich dann aus dem Durchmesser des Hüllkreises 2.

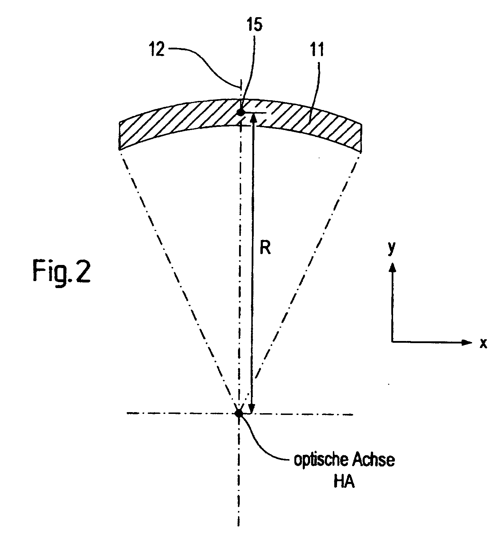

In Figur 2 ist das Objektfeld 11 einer Projektionsbelichtungsanlage in der Objektebene des Projektionsobjektives dargestellt, das mit Hilfe des erfindungsgemäßen Projektionsobjektives in eine Bildebene, in der ein lichtempfindliches Objekt, beispielsweise ein Wafer angeordnet ist, abgebildet wird. Das Bildfeld in der Bildebene weist dieselbe Form auf wie das Objektfeld. Das Objekt- bzw. Bildfeld 11 hat die Gestalt eines Segmentes eines Ringfeldes. Das Segment weist eine Symmetrieachse 12 auf.

Des weiteren sind in Figur 2 die die Objektebene aufspannenden Achsen, nämlich die x-Achse und die y-Achse eingezeichnet. Wie aus Figur 2 zu entnehmen, verläuft die Symmetrieachse 12 des Ringfeldes 11 in Richtung der y-Achse. Gleichzeitig fällt die y-Achse mit der Scan-Richtung einer EUV-Projektionsbelichtungsanlage, die als Ringfeldscanner ausgelegt ist, zusammen. Die x-Richtung ist dann die Richtung, die innerhalb der Objektebene senkrecht auf der Scan-Richtung steht. Das Ringfeld weist einen sogenannten mittleren Ringfeldradius R auf, der durch den Abstand des Mittelpunktes 15 des Bildfeldes von der optischen Achse HA des Projektionsobjektives definiert ist.

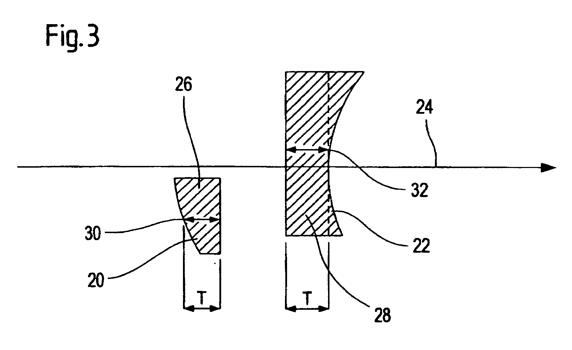

In Figur 3 sind beispielhaft für das Gesamtsystem zwei Spiegelsegmente 20, 22 eines erfindungsgemäßen Projektionsobjektives gezeigt, wobei die Spiegelsegmente 20, 22 mit den Nutzbereichen des Spiegels korrespondieren. Die Spiegelsegmente sind entlang einer optischen Achse 24 angeordnet. Wie aus Figur 3 des weiteren ersichtlich, ist jedem Nutzbereich 20, 22 eines Spiegels des Projektionsobjektives ein Bauraum 26, 28 zugeordnet. Unter der Tiefe T des Bauraumes wird in vorliegender Anmeldung die Ausdehnung des Bauraumes vom Mittelpunkt 30, 32 des Nutzbereichs 20, 22 eines jeden Spiegels parallel zur optischen Achse verstanden. Als Mittelpunkt des Nutzbereiches wird in vorliegender Anmeldung der Auftreffpunkt des Hauptstrahles CR des zentralen Feldpunktes des Objektfeldes auf den Nutzbereich des jeweiligen Spiegels verstanden. Wie in Figur 3 dargestellt sind die Spiegel im Projektionsobjektiv derart angeordnet, daß sich die Bauräume 26, 28 geometrisch nicht durchdringen.

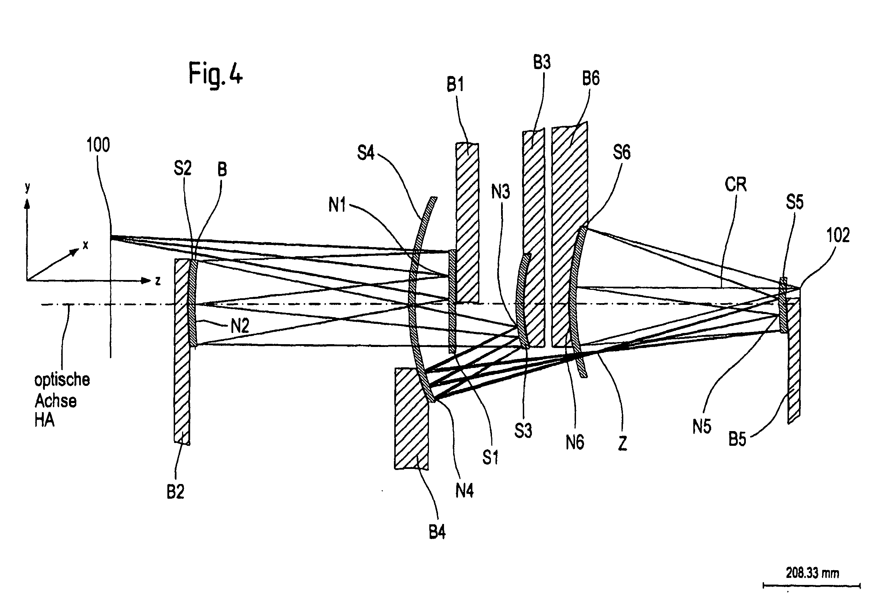

In Figur 4 ist ein erstes Ausführungsbeispiel eines erfindungsgemäßen 6-Spiegel-Systems gezeigt, wobei die Größe des abzubildenden Objektes, das das Segment eines Ringfeldes darstellt und eine Symmetrieachse wie in Figur 2 dargestellt aufweist, in Richtung senkrecht zur Symmetrieachse mindestens 20, bevorzugt 25 mm ist. Das abzubildende Objekt befindet sich in der Objektebene 100 des in der Figur 4 dargestellten Objektives. In der Objektebene 100 wird als Objektfeld in vorliegendem Beispiel ein Ringfeldsegment ausgebildet . Desweiteren ist in der Objektebene das auf eine lichtempfindliche Schicht abzubildende Objekt, das in der Lithographie auch als Retikel bezeichnet wird, angeordnet.

Die Ebene, in die das Objekt 100 durch das erfindungsgemäße Projektionsobjektiv abgebildet wird, ist die Bildebene 102, in der beispielsweise ein Wafer angeordnet sein kann. Das erfindungsgemäße Projektionsobjektiv umfaßt einen ersten Spiegel S1, einen zweiten Spiegel S2, einen dritten Spiegel S3, einen vierten Spiegel S4, einen fünften Spiegel S5 sowie einen sechsten Spiegel S6. Bei dem in Figur 4 dargestellten Ausführungsbeispiel sind sämtliche sechs Spiegel S1, S2, S3, S4, S5 und S6 als asphärische Spiegel ausgebildet. Bei dem ersten Spiegel S1 handelt es sich um einen Konvex -Spiegel.

Die Blende B ist bei dem ersten Ausführungsbeispiel gemäß Figur 4 auf dem zweiten Spiegel S2 angeordnet. Das System ist zur optischen Achse HA zentriert und bildseitig, d.h. in der Bildebene 102 telezentrisch. Unter bildseitiger Telezentrie versteht man, daß der Hauptstrahl CR unter einem Winkel von nahe oder ungefähr 90° auf die Bildebene 102 trifft.

Um die Lichtverluste und die beschichtungsinduzierten Wellenfrontabberationen innerhalb des Spiegelsystems möglichst gering zu halten, ist der Auftreffwinkel des Hauptstrahles CR des zentralen Feldpunktes auf die jeweilige Spiegeloberfläche stets kleiner als 18°. In Figur 4 ebenfalls eingezeichnet sind die Bauräume B1, B2, B3, B4, B5 und B6 der Nutzbereiche N1, N2, N3, N4, N5 und N6 der jeweiligen Spiegel S1, S2, S3, S4, S5 und S6.

Wie aus Figur 4 deutlich zu erkennen, ist das Gesamtobjektiv derart aufgebaut, daß alle Bauräume B1, B2, B3, B4, B5 und B6 in eine Richtung parallel zur Symmetrieachse 12 des in der Ebene 100 liegenden Objektfeldes ausdehnbar sind, ohne daß der Lichtweg im Objektiv oder der Bauraum eines anderen Spiegels geschnitten wird. Zur leichteren Lesbarkeit ist in Figur 4 ein Koordinatensystem x, y, z eingezeichnet. Die optische Achse des Objektives verläuft in z-Richtung, das Objektfeld liegt in der x-y-Objektebene und die Symmetrieachse des Objektfeld 100 weist in y-Richtung.

Wie aus Figur 4 hervorgeht sind die Bauräume aller Nutzbereiche in Richtung der Symmetrieachse 12 des Objektfeldes ausdehnbar. Dies stellt sicher, daß die Spiegel von wenigstens einer Seite des Objektives her zugänglich sind und beispielsweise eingefaßt und montiert werden können.

Des weiteren handelt es sich bei dem Ausführungsbeispiel 1 gemäß Figur 4 um ein System mit Zwischenbild Z. Das Zwischenbild Z wird geometrisch nach dem ersten Spiegel S1 zwischen viertem und fünftem Spiegel S4,S5 ausgebildet. Durch das Zwischenbild Z wird das System gemäß Figur 4 in zwei Teilsysteme, ein erstes Teilsystem umfassend die Spiegel S1, S2, S3 und S4 sowie in ein zweites Teilsystem umfassend die Spiegel S5 und S6 geteilt.

Der Bauraum B1 bis B4 und B6 der Spiegel S1 bis S4 und S6 beträgt mindestens 50 mm, der Bauraum B5 des fünften Spiegels mindestens ein Drittel des Durchmessers des Nutzbereichs des fünften Spiegels, so daß ein freier Arbeitsabstand zwischen dem wafernächsten fünften Spiegel S5 und der Bildebene 102 von mindestens 12 mm garantiert wird.

Die Code V-Daten des ersten Ausführungsbeispieles gemäß Figur 4 sind in Tabelle 1, die im Anhang wiedergegeben ist, angegeben. Hierbei bezeichnet die Element-Nr. 1, 2, 3, 4, 5, 6 die Spiegel S1, S2, S3, S4, S5 sowie S6.

Die bildseitige numerische Apertur des Systems gemäß Ausführungsbeispiel 1 beträgt 0,25.

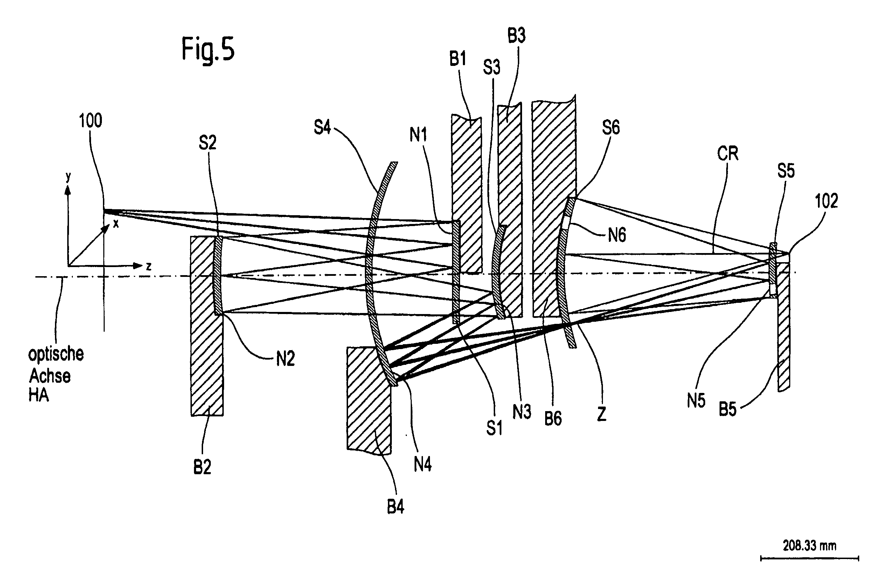

In Figur 5 ist ein zweites Ausführungsbeispiel der Erfindung gezeigt. Gleiche Bauteile wie in Figur 4 sind mit denselben Bezugsziffern belegt Wiederum sind alle sechs Spiegeloberflächen asphärisch, im Gegensatz zur Ausführungsform gemäß Figur 4 ist jedoch der erste Spiegel S1 nicht konvex, sondern konkav ausgebildet.

Die Daten des Systems sind in der in Tabelle 2 im Anhang der Anmeldung wiedergebenen Code V-Tabelle angegeben. Die numerische Apertur des Projektionsobjektives gemäß Figur 5 beträgt wie schon im Falle der ersten Ausführungsform gemäß Figur 4 NA = 0,25.

Bei dem Ausführungsbeispiel gemäß Figur 5 sind erfindungsgemäß die Durchmesser D der Nutzbereiche aller im Objektiv angeordneten Spiegel kleiner als 300 mm, wobei das abzubildende Objekt das Segment eines Ringfeldes ist, wie in Figur 2 dargestellt.

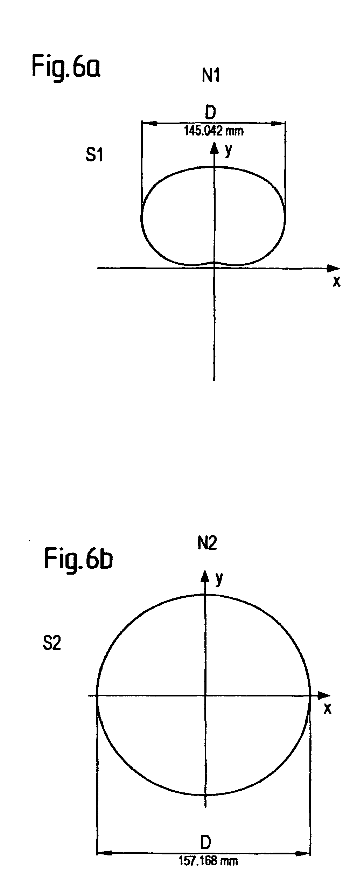

Die Nutzbereiche in der x-y-Ebene der jeweiligen Spiegel des zweiten Ausführungsbeispieles gemäß Figur 5 ist in den Figuren 6a bis 6f gezeigt. In allen Abbildungen eingezeichnet ist das x-y-Koordinatensystem, wie durch die Objektebene definiert. Hierbei bezeichnet die y-Richtung die Richtung in Richtung der Scan-Richtung eines Ringfeldscanners und die x-Richtung die Richtung senkrecht zur Scan-Richtung.

Wie aus Figur 6a hervorgeht, ist der Nutzbereich N1 auf dem Spiegel S1 im wesentlichen nierenförmig und weist einen Durchmesser D wie in Figur 1 definiert, von 145,042 mm auf. Der Durchmesser des Nutzbereiches N2 auf dem Spiegel S2 ist im wesentlichen kreisförmig, der Durchmesser beträgt 157,168 mm gemäß Figur 6b.

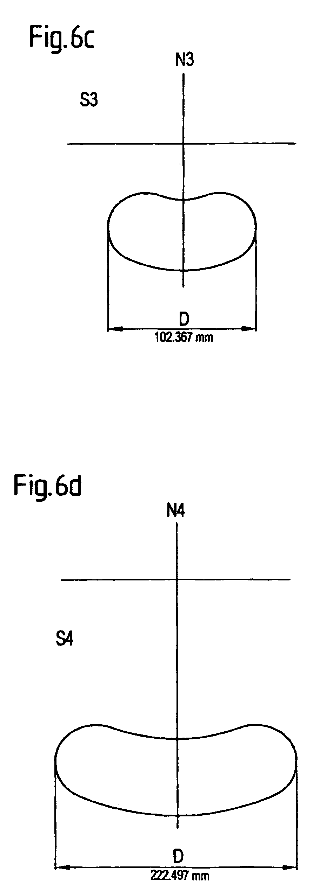

Beim Spiegel S3 ist der Nutzbereich N3 wiederum nierenförmig, der Durchmesser D beträgt 102,367 mm gemäß Figur 6c und beim Spiegel S4 weist der Nutzbereich N4 gemäß Figur 6d einen Durchmesser von 222,497 mm auf.

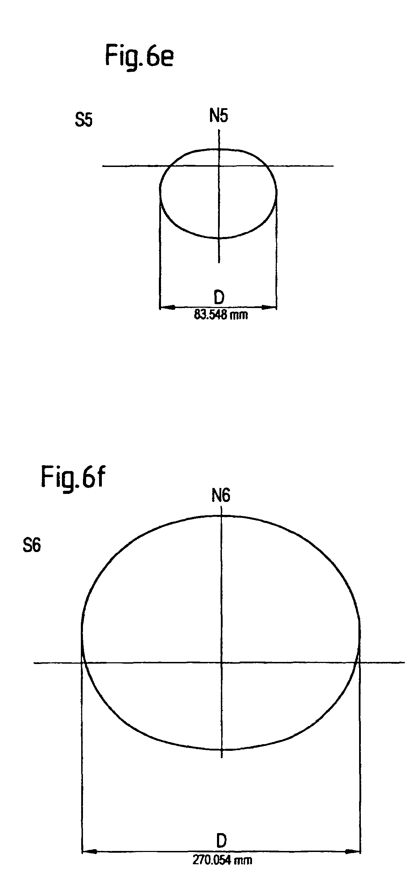

Die Nutzbereiche N5 und N6 gemäß den Figuren 6e und 6f auf den Spiegeln S5 und S6 sind im wesentlichen kreisförmig, der Durchmesser D des Nutzbereiches N5 beträgt 83,548 mm und der Durchmesser D des Nutzbereiches N6 270,054 mm.

Erfindungsgemäß ist somit der Durchmesser sämtlicher Nutzbereiche N1 bis N6 der Ausführungsform des Projektionsobjektives gemäß Figur 5 kleiner als 300 mm.

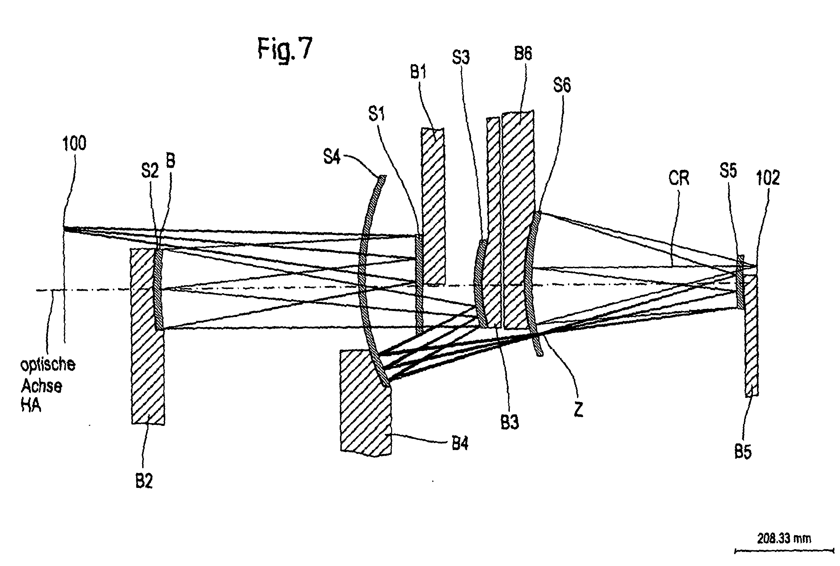

In Figur 7 ist eine dritte Ausführungsform eines erfindungsgemäßen Projektionsobjektives mit sechs asphärischen Spiegeln gezeigt. Wiederum sind für gleiche Bauteile wie in den Figuren 4 und 6 dieselben Bezugsziffern verwendet. Die Daten der dritten Ausführungsform gemäß Figur 7 sind in der im Anhang wiedergegebenen Tabelle 3 im Code V-Format angegeben. Die numerische Apertur des Systems gemäß Figur 7 beträgt NA=0,25. Der erste Spiegel S1 des Ausführungsbeispieles in Figur 7 ist paraxial plan ausgebildet. Hierunter versteht man in der vorliegenden Anmeldung, daß die Grundkrümmung des Spiegels S1 in der Nähe der optischen Achse HA identisch Null ist.

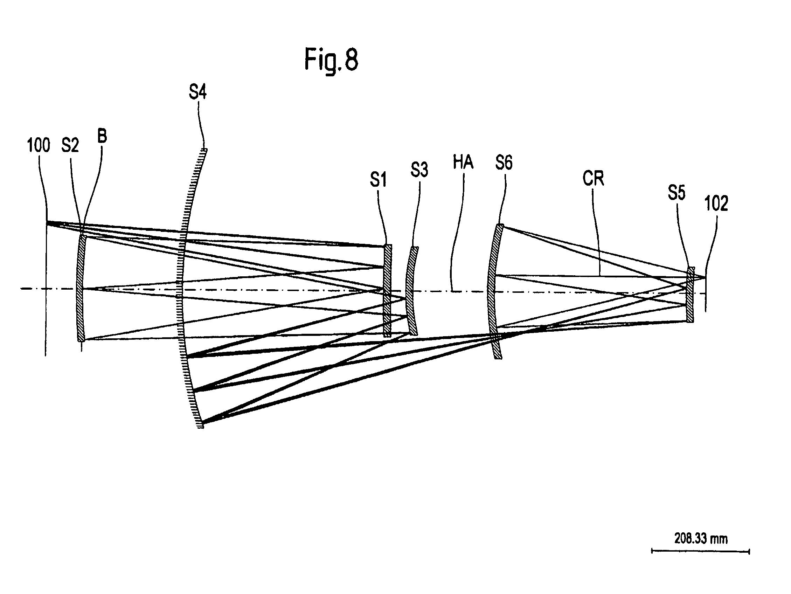

Ein aus Fertigungsgesichtspunkten besonders vorteilhaftes 6-Spiegel-System zeigt Figur 8. Bei dem System gemäß Figur 8 beträgt die numerische Apertur 0,23, der vierte Spiegel ist ein sphärischer Spiegel, was unter Fertigungsgesichtspunkten sehr vorteilhaft ist, da sphärische Flächen leichter als asphärische Flächen zu bearbeiten sind und der vierte Spiegel S4 der Spiegel mit dem am weitesten von der optischen Achse entfernten Nutzbereich ist.

Die Daten des Systems gemäß Figur 8 sind in Tabelle 4 im Anhang im Code V-Format wiedergegeben.

Für die relativ geringen Abmessungen der Nutzbereiche der Spiegel, insbesondere des vierten Spiegels, ist die Lage des vierten Spiegels geometrisch zwischen drittem und zweitem bzw. erstem und zweitem Spiegel im Projektionsobjektiv verantwortlich.

Die Daten betreffend die Lage des vierten Spiegels in bezug auf den zweiten und ersten Spiegel bzw. den zweiten und dritten Spiegel werden durch nachfolgende Bedingungen beschrieben:

$$0,1 < \frac{(S4, S1)}{(S2, S1)} < 0,9 \qquad (1)$$

$$0,3 < \frac{(S3, S4)}{(S2, S3)} < 0,9 \qquad (2)$$

Bevorzugt gilt für Bedingung (2):

$$0,4 < \frac{(S3, S4)}{(S2, S3)} < 0,9 \qquad (2a)$$

Diese Bedingungen sind für die vier Ausführungsbeispiele in den nachfolgenden Tabellen wiedergegeben.

Tabelle 5:

| Daten zur Bedingung (1) | | |
|---|---|---|
| **Ausführungs-beispiel** | **Eigenschaft** | **(S4S1)/ (S2S1)** |
| 1 = Figur 4 | M1 konvex | 0.14 |
| 2 = Figur 5 | M1 konkav | 0.35 |
| 3 = Figur 7 | M1 plan | 0.19 |
| 4 = Figur 8 | NA = 0.23, 5 Asphären | 0.67 |

Tabelle 6:

| Daten zur Bedingung (2) | | |
|---|---|---|
| **Ausführungs-beispiel** | **Eigenschaft** | **(S3S4)/ (S2S3)** |
| 1 = Figur 4 | M1 konvex | 0.31 |
| 2 = Figur 5 | M1 konkav | 0.44 |
| 3 = Figur 7 | M1 plan | 0.34 |
| 4 = Figur 8 | NA = 0.23, 5 Asphären | 0.69 |

Der Durchmesser der Nutzbereiche ist insbesondere deswegen ein wichtiger Parameter, da sie die Abmessungen der Objektivkammer festlegen. Große Nutzbereiche und damit große Spiegel beanspruchen einen sehr großen Bauraum, was unter dem Gesichtspunkt der Evakuierung eines größeren UHV-Systems nachteilhaft ist. Ein weiterer Nachteil großer Spiegel ist deren größere Empfindlichkeit gegenüber mechanischen Schwingungen, da ihre Eigenfrequenz kleiner ist als bei kleineren Spiegeln. Ein weiterer Vorteil von Spiegeln mit geringen Abmessungen liegt darin, daß die Asphärisierung und Beschichtung der Substrate in kleineren UHV-Bearbeitungskammern erfolgen kann.

Da die Beschichtung der Spiegelsubstrate mit den Vielfachschichtsystemen zu Schichtspannungen führen, können insbesondere am Rand des Substrates Deformationen auftreten. Damit diese sich nicht in den Nutzbereich des Spiegels fortsetzen, ist es notwendig, außerhalb des Nutzbereiches einen Mindestüberlauf vorzusehen, innerhalb dessen die Deformationen abklingen können. Der Randbereich der einzelnen Spiegel in den Ausführungsbeispielen 1 bis 4 ist in nachfolgender Tabelle 7 wiedergegeben.

Tabelle 7:

| Daten zu den Randbereichen der Spiegel S1 bis S6 | | | | |
|---|---|---|---|---|
| **Spiegel** | **A1 = Figur 4** | **A2 = Figur 5** | **A3 = Figur 7** | **A4 = Figur 8** |
| S1 | 13 mm | 21 mm | 16 mm | 2 mm |
| S2 | 11 mm | 11 mm | 8 mm | 8 mm |
| S3 | 22 mm | 28 mm | 26 mm | 8 mm |
| S5 | 4 mm | 4 mm | 4 mm | 5 mm |
| S6 | 5 mm | 6 mm | 5 mm | 2 mm |

Wie hieraus zu ersehen ist, beträgt der Randbereich bei den Ausführungsformen gemäß Figur 4, 5 und 7 für jeden Spiegel mehr als 4 mm, was für die fassungstechnische Berücksichtigung von Schichtspannungen besonders vorteilhaft ist.

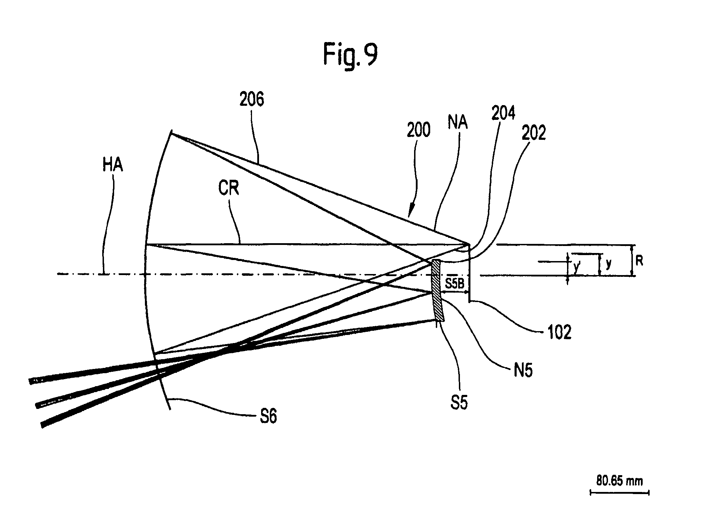

In Figur 9 ist die Anordnung von fünftem und sechstem Spiegel S5, S6 bei einer vorteilhaften Ausführungsform eines Projektionsobjektiv gemäß der Erfindung gezeigt.

Gemäß Figur 9 trifft das abbildende Strahlbündel 200 auf die Bildebene 102, in der beispielsweise ein Wafer angeordnet ist, telezentrisch auf. Der sechste Spiegel S6 ist konkav geformt. Der fünfte Spiegel S5 liegt zwischen dem sechsten Speigel S6 und der Bildebene 102. Bei den erfindungsgemäßen Projektionsobjektiven sind alle Spiegel S1, S2, S3, S4, S5, S6 zwischen Objektebene 100 und Bildebene 102 angeordnet. Fordert man einen abschattungsfreien Strahlengang in dem erfindungsgemäßen Projektionsobjektiv, so existieren im in Figur 9 gezeigten bildseitigen Objektivteil mit den Spiegeln S5 und S6 zwei kritische Bereiche für eine abschattungsfreie Strahlführung.

Der eine Bereich liegt am oberen Rand 202 des Nutzbereiches des fünften Spiegels S5. Die Strahlführung muß so konstruiert sein, daß die unteren Randstrahlen 204 des Strahlbündels 200 oberhalb des Nutzbereiches N5 dieses Spiegels S5 verlaufen und auf die Bildebene 102 treffen. Bezeichnet R den Ringfeldradius und ( S5 B ) den Abstand zwischen S5 und der Bildebene 102, so ist der Abstand der unteren Randstrahlen 204 von der optischen Achse HA durch die Beziehung

$$y = R - ( S5\ B ) * \tan(\arcsin(NA))$$

gegeben, wobei NA die numerische Apertur an der Austrittspupille bezeichnet.

Die obere Grenze des Nutzbereiches N5 wird durch den Auftreffpunkt der oberen Randstrahlen 206 des Strahlbündels 200 auf den fünften Spiegel S5 festgelegt. Unter Verwendung der Variablen

$r_6$: Krümmungsradius von S6
(S5 S6): (positiver) Abstand zwischen S5 und S6

liefert die Anwendung der Schnittweitengleichung auf den sechsten Spiegel S6 für den Abstand y' des oberen Randes 202 des Nutzbereiches N5 des fünften Spiegels von der optischen Achse HA:

$$y' = \left[ \cfrac{1}{\cfrac{2}{r_6} - \cfrac{1}{( S5\ B ) + ( S5\ S6 ) + \cfrac{R}{\tan(\arcsin(NA))}}} - ( S5 S6 ) \right]$$

$$\tan\left[ \arcsin(NA) + 2\arcsin\left( \frac{NA}{r_6} * \left( ( S5B ) + ( S5S6 ) - r_6 + \frac{R}{\tan(\arcsin(NA))} \right) \right) \right]$$

Um einen obskurationsfreien Strahlverlauf am fünften Spiegel S5 zu erreichen, muß dann gelten:

$$\Delta\ y = y - y' \geq 0$$

Der andere kritische Bereich liegt am unteren Rand von S6. Um an dieser Stelle Abschattungsfreiheit in paraxialer Näherung zu gewährleisten, ergibt sich nach zweimaliger Anwendung der Schnittweitengleichung auf S5 und S6 für den Ringfeldradius R des Bildfeldes in der Bildebene 102:

$$R \geq \tan\ (\arc\ \sin\ (NA))\ * \left[\ (S5\ B)\ +\ (S5\ S6)\ -\ \cfrac{1}{\cfrac{2}{r_6} - \cfrac{1}{r_5 + (S5\ S6)}}\ \right]$$

Wählt man $r_6$, $r_5$, $(S_5B)$ sowie $(S_5S_6)$ fest und zwar

$r_6$ = 535,215 mm;   $r_5$ = 594,215 mm;
(S5 B) = 44,083 mm;   (S5 S6) = 437,186 mm,

so ergibt sich folgende Tabelle 5 aus obiger Formel für den Ringfeldradius R in Abhängigkeit von der Apertur unter der Randbedingung obskurationsfreier Strahlführung am fünften Spiegel gemäß den Formeln für y' und $\Delta$y :

Tabelle 5:

| NA | 0,15 | 0,20 | 0,25 | 0,30 |
|---|---|---|---|---|
| R in [mm] | 18,191 | 24,475 | 30,958 | 37,707 |

Wie aus Tabelle 5 zu erkennen, hat eine große numerische Apertur NA an der Austrittspupille einen großen Ringfeldradius zur Folge.

Bei vorgegebenem Ringfeldradius ist eine Aperturvergrößerung bei koaxialen 6-Spiegel-Objektiven nur bis zu einem bestimmten Wert möglich. Oberhalb dieses Wertes beobachtet man einen nahezu sprunghaften Anstieg der Asphärizität auf dem fünften Spiegel, welcher zu Problemen in Asphärenfertigung und -meßtechnik sowie Problemen bei der Korrektur des Objektives führt.

(S5 B) ist mit dem sogenannten Arbeitsabstand des Objektives am Wafer gleichzusetzen, der eine MindestgröBe nicht unterschreiten darf. Eine Verringerung des Ringfeldradius durch eine Verkleinerung von (S5 B) ist also nur bis zur Erreichung des Mindestabstandes möglich.

Eine Verkleinerung des Abstandes (S5 S6) führt zwar zu kleineren Ringfeldradien, vergrößert aber andererseits die Einfallswinkel auf dem fünften Spiegel S5. Die großen Einfallswinkel auf S5 wiederum erlauben nur mit sehr großem Aufwand die Herstellung von Multischichtsystem mit optimalem Reflexionsvermögen. Eine Verkleinerung von $r_5$ führt zu denselben Nachteilen wie die Verkleinerung des Abstandes (S5 S6), da auch eine derartige Verkleinerung mit großen Einfallswinkeln auf S5 einhergeht.

Eine Vergrößerung von $r_6$ liefert zwar kleinere Ringfeldradien, allerdings wird die Obskurationsfreiheit am fünften Spiegel verletzt.

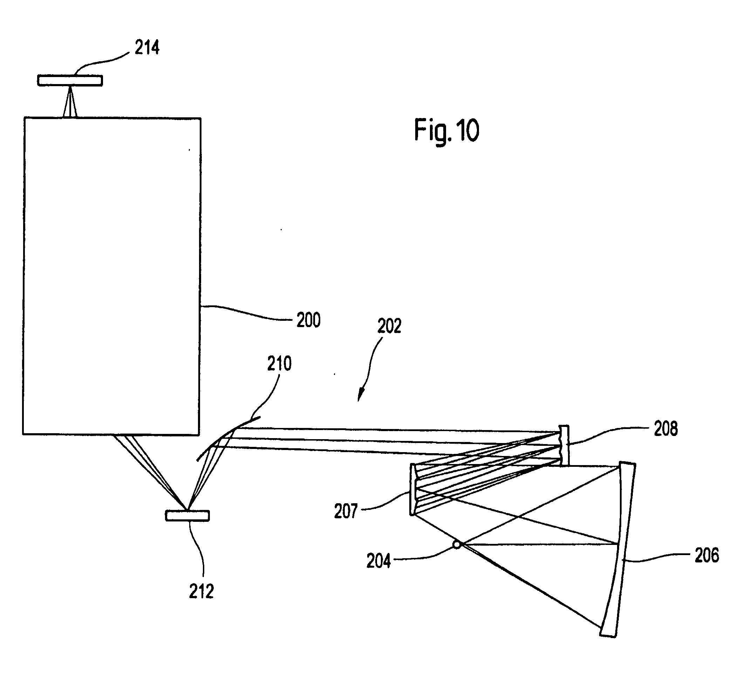

In Figur 10 ist eine Projektionsbelichtungsanlage für die Mikrolithographie mit einem erfindungsgemäßen 6-Spiegel-Projektionsobjektiv 200 dargestellt. Das Beleuchtungssystem 202 kann wie beispielsweise in der EP 99106348.8 mit dem Titel "Beleuchtungssystem, insbesondere für die EUV-Lithographie" oder US-Serial No 09/305,017 mit dem Titel "illumination system particularly for EUV-Lithography" beschrieben, deren Offenbarungsgehalt vollumfänglich in die vorliegende Anmledung mitaufgenommen wird, ausgebildet sein. Ein derartiges Beleuchtungssystem umfasst eine EUV-Lichtquelle 204. Das Licht der EUV-Lichtquelle wird vom Kollektorspiegel 206 gesammelt. Mit Hilfe eines ersten Spiegels 207 umfassend Rasterelemente - sogenannte Feldwaben - und eines zweiten Spielgels 208 umfassend Rasterelemente - sogenannte Pupillenwaben - sowie eines Spiegels 210 wird das Retikel 212 beleuchtet. Das vom Retikel 212 reflektierte Licht wird mittels des erfindungsgemäßen Projektionsobjektives auf einen Träger 214 umfassend eine lichtempfindliche Schicht abgebildet.

Mit der Erfindung wird somit erstmals ein Projektionsobjektiv mit sechs Spiegeln angegeben, das sich durch Nutzbereiche mit geringen Abmessungen auf allen Spiegeln auszeichnet und insoweit ein aus konstruktionstechnischer und fertigungtechnischer Sicht besonders vorteilhaftes, kompaktes Projektionsobjektiv darstellt.

Bezugszeichenliste

Z:      Hüllkreis

6, 8:      Punkte, an denen der Hüllkreis mit dem nierenförmig ausgeleuchteten Feld zusammenfällt

10:      Rand des nierenförmig ausgeleuchteten Feldes
11:      Objektfeld
12:      Symmetrieachse des Ringfeldes
15:      Mittelpunkt des Objekt- bzw. Bildfeldes

20, 22:      Spiegelsegmente
26, 28:      Bauraum
30, 32:      Mittelpunkt des Nutzbereiches

100:      Objektebene
102:      Bildebene

200:      abbildendes Strahlbündel
202:      oberer Rand des Nutzbereiches N5 an S5
204:      untere Randstrahlen
206:      obere Randstrahlen

S1:                      erster Spiegel
S2:                      zweiter Spiegel
S3:                      dritter Spiegel
S4:                      vierter Spiegel
S5:                      fünfter Spiegel
S6:                      sechster Spiegel
B1, B2, B3, B4, B5, B6:      den Spiegeln zugeordnete Bauräume

N1, N2, N3, N4, N5, N6:      an den Spiegeln zugeordnete Nutzbereiche

x, y, z:      Koordinaten des Koordinatensystems in der Objekt- und Bildebene
HA:      optische Achse des Projektionsobjektives
NA:      numerische Apertur an der Austrittspupille
R:      Ringfeldradius
CR:      Hauptstrahl
B:      Blende
Z:      Zwischenbild
D:      Durchmesser des Nutzbereiches

## Anhang: Tabellen 1 - 4 Code V - Objektivdaten

### Tabelle 1: Ausführungsbeispiel 1 (Figur 4)

| ELEMENT NUMMER | RADIUS | DICKE | DURCHMESSER | ART |
|---|---|---|---|---|
| OBJEKT | INF | 743.3276 | | |
| 1 | A(1) | -557.1863 | 210.8986 | REFL |
| | | APERTURBLENDE | 177.1640 | |
| | | 0.0000 | | |
| 2 | A(2) | 702.9968 | 177.3847 | REFL |
| 3 | A(3) | -221.1310 | 191.0743 | REFL |
| 4 | A(4) | 787.9929 | 426.0706 | REFL |
| 5 | A(5) | -436.7697 | 110.1796 | REFL |
| 6 | A(6) | 480.7697 | 310.6813 | REFL |
| BILD | INF | | 70.5007 | |

ASPHÄRISCHE KONSTANTEN

$$Z = \frac{(CURV)Y^2}{1 + (1-(1+K)(CURV)^2 Y^2)^{1/2}} + (A)Y^4 + (B)Y^6 + (C)Y^8 + (D)Y^{10} + (E)Y^{12} + (F)Y^{14} + (G)Y^{16} + (H)Y^{18} + (J)Y^{20}$$

| ASPHÄRE | CURV | K / E | A / F | B / G | C / H | D / J |
|---|---|---|---|---|---|---|
| A( 1) | 0.00006144 | 0.000000 | 5.48969E-10 | -4.47710E-15 | 6.93597E-20 | -1.61832E-24 |
| | | 1.87256E-29 | 0.00000E+00 | 0.00000E+00 | 0.00000E+00 | 0.00000E+00 |
| A( 2) | 0.00092955 | 0.000000 | -4.50667E-11 | -3.63055E-16 | -3.52050E-21 | 7.46570E-26 |
| | | -7.88639E-30 | 0.00000E+00 | 0.00000E+00 | 0.00000E+00 | 0.00000E+00 |
| A( 3) | 0.00284106 | 0.000000 | -3.98337E-10 | -2.92857E-15 | 8.46286E-19 | -5.98614E-23 |
| | | 1.64447E-27 | 0.00000E+00 | 0.00000E+00 | 0.00000E+00 | 0.00000E+00 |
| A( 4) | 0.00193867 | 0.000000 | -3.55491E-12 | 7.43877E-17 | -5.36969E-22 | 2.36533E-26 |
| | | -1.71616E-31 | 0.00000E+00 | 0.00000E+00 | 0.00000E+00 | 0.00000E+00 |
| A( 5) | 0.00179551 | 0.000000 | 5.44569E-09 | 1.45719E-13 | -5.07132E-18 | 1.13331E-21 |
| | | -9.96256E-26 | 0.00000E+00 | 0.00000E+00 | 0.00000E+00 | 0.00000E+00 |
| A( 6) | 0.00186905 | 0.000000 | 6.69863E-11 | 3.06114E-16 | 1.29123E-21 | 2.82784E-27 |
| | | 4.44608E-32 | 0.00000E+00 | 0.00000E+00 | 0.00000E+00 | 0.00000E+00 |

REFERENZWELLENLÄNGE = 13.4 NM
ABBILDUNGSMASSSTAB = 0.25
BILDSEITIGE APERTUR = 0.25

## Tabelle 2: Ausführungsbeispiel 2 (Figur 5)

| ELEMENT NUMMER | RADIUS | DICKE | DURCHMESSER | ART |
|---|---|---|---|---|
| OBJEKT | INF | 763.1539 | | |
| 1 | A(1) | -508.8959 | 217.5892 | REFL |
| | | APERTURBLENDE | 157.2988 | |
| | | 0.0000 | | |
| 2 | A(2) | 592.9977 | 157.6458 | REFL |
| 3 | A(3) | -263.0251 | 186.9465 | REFL |
| 4 | A(4) | 857.5155 | 464.9979 | REFL |
| 5 | A(5) | -437.1855 | 110.6968 | REFL |
| 6 | A(6) | 481.2681 | 311.8894 | REFL |
| BILD | INF | | 70.8868 | |

ASPHÄRISCHE KONSTANTEN

$$Z = \frac{(CURV)Y^2}{1 + (1-(1+K)(CURV)^2 Y^2)^{1/2}} + (A)Y^4 + (B)Y^6 + (C)Y^8 + (D)Y^{10}$$
$$+ (E)Y^{12} + (F)Y^{14} + (G)Y^{16} + (H)Y^{18} + (J)Y^{20}$$

| ASPHÄRE | CURV | K / E | A / F | B / G | C / H | D / J |
|---|---|---|---|---|---|---|
| A( 1) | -0.00009342 | 0.000000 / 3.09845E-29 | 5.02048E-10 / 0.00000E+00 | -3.59798E-15 / 0.00000E+00 | 4.65491E-20 / 0.00000E+00 | -1.24487E-24 / 0.00000E+00 |
| A( 2) | 0.00094495 | -0.000000 / 0.00000E+00 | -8.64008E-11 / 0.00000E+00 | -8.21885E-16 / 0.00000E+00 | -7.41356E-21 / 0.00000E+00 | -3.30260E-25 / 0.00000E+00 |
| A( 3) | 0.00281349 | 0.000000 / -3.93860E-27 | -8.95729E-10 / 0.00000E+00 | 1.08088E-14 / 0.00000E+00 | -1.55198E-18 / 0.00000E+00 | 1.20451E-22 / 0.00000E+00 |
| A( 4) | 0.00176899 | 0.799352 / -1.67295E-30 | -6.05769E-10 / 0.00000E+00 | -1.14820E-15 / 0.00000E+00 | -3.64542E-20 / 0.00000E+00 | 2.50132E-25 / 0.00000E+00 |
| A( 5) | 0.00182078 | 0.000000 / -8.77929E-26 | 5.28849E-09 / 0.00000E+00 | 1.32507E-13 / 0.00000E+00 | -2.78314E-18 / 0.00000E+00 | 7.00685E-22 / 0.00000E+00 |
| A( 6) | 0.00186581 | 0.000000 / 5.80814E-32 | 6.68738E-11 / 0.00000E+00 | 3.06141E-16 / 0.00000E+00 | 1.34385E-21 / 0.00000E+00 | 1.39691E-27 / 0.00000E+00 |

REFERENZWELLENLÄNGE = 13.4 NM
ABBILDUNGSMASSSTAB = 0.25
BILDSEITIGE APERTUR = 0.25

## Tabelle 3: Ausführungsbeispiel 3 (Figur 7)

| ELEMENT NUMMER | RADIUS | DICKE | DURCHMESSER | ART |
|---|---|---|---|---|
| OBJEKT | INF | 767.2557 | | |
| 1 | A(1) | -555.7033 | 216.0671 | REFL |
| | | APERTURBLENDE | 173.9832 | |
| | | 0.0000 | | |
| 2 | A(2) | 682.2766 | 174.2476 | REFL |
| 3 | A(3) | -233.6859 | 188.2262 | REFL |
| 4 | A(4) | 794.6148 | 428.4357 | REFL |
| 5 | A(5) | -436.8293 | 110.5239 | REFL |
| 6 | A(6) | 480.8400 | 310.5587 | REFL |
| BILD | INF | | 70.4765 | |

ASPHÄRISCHE KONSTANTEN

$$Z = \frac{(CURV)Y^2}{1 + (1-(1+K)(CURV)^2 Y^2)^{1/2}} + (A)Y^4 + (B)Y^6 + (C)Y^8 + (D)Y^{10} + (E)Y^{12} + (F)Y^{14} + (G)Y^{16} + (H)Y^{18} + (J)Y^{20}$$

| ASPHÄRE | CURV | K<br>E | A<br>F | B<br>G | C<br>H | D<br>J |
|---|---|---|---|---|---|---|
| A( 1) | 0.00000000 | 0.000000<br>2.03931E-29 | 5.67634E-10<br>0.00000E+00 | -4.28505E-15<br>0.00000E+00 | 6.16577E-20<br>0.00000E+00 | -1.42715E-24<br>0.00000E+00 |
| A( 2) | 0.00092352 | 0.000000<br>-7.88639E-30 | -4.50667E-11<br>0.00000E+00 | -3.63055E-16<br>0.00000E+00 | -3.52050E-21<br>0.00000E+00 | 7.46570E-26<br>0.00000E+00 |
| A( 3) | 0.00277871 | 0.000000<br>1.08438E-27 | -3.26329E-10<br>0.00000E+00 | -7.02528E-16<br>0.00000E+00 | 5.33788E-19<br>0.00000E+00 | -3.92007E-23<br>0.00000E+00 |
| A( 4) | 0.00188296 | 0.000000<br>-6.94542E-31 | -9.51406E-12<br>0.00000E+00 | 5.06179E-16<br>0.00000E+00 | -9.93523E-21<br>0.00000E+00 | 1.33054E-25<br>0.00000E+00 |
| A( 5) | 0.00185628 | 0.000000<br>-1.05073E-25 | 5.15785E-09<br>0.00000E+00 | 1.54832E-13<br>0.00000E+00 | -5.20812E-18<br>0.00000E+00 | 1.16863E-21<br>0.00000E+00 |
| A( 6) | 0.00186897 | 0.000000<br>6.23447E-32 | 6.62264E-11<br>0.00000E+00 | 2.99098E-16<br>0.00000E+00 | 1.29774E-21<br>0.00000E+00 | 1.07497E-27<br>0.00000E+00 |

| | | |
|---|---|---|
| REFERENZWELLENLÄNGE = | 13.4 NM | |
| ABBILDUNGSMASSSTAB = | 0.25 | |
| BILDSEITIGE APERTUR = | 0.25 | |

## Tabelle 4: Ausführungsbeispiel 4 (Figur 8)

| ELEMENT NUMMER | RADIUS | DICKE | DURCHMESSER | ART |
|---|---|---|---|---|
| OBJEKT | INF | 739.9848 | | |
| 1 | A(1) | −659.9848 | 188.6091 | REFL |
| | | APERTURBLENDE 0.0000 | 219.3872 | |
| 2 | A(2) | 709.9848 | 219.1277 | REFL |
| 3 | A(3) | −492.0904 | 179.7699 | REFL |
| 4 | 847.3874 CC | 1094.5501 | 577.4446 | REFL |
| 5 | A(4) | −412.2537 | 109.4460 | REFL |
| 6 | A(5) | 452.2537 | 273.6442 | REFL |
| BILD | INF | | 71.0012 | |

ASPHÄRISCHE KONSTANTEN

$$Z = \frac{(CURV)Y^2}{1 + (1-(1+K)(CURV)^2 Y^2)^{1/2}} + (A)Y^4 + (B)Y^6 + (C)Y^8 + (D)Y^{10}$$
$$+ (E)Y^{12} + (F)Y^{14} + (G)Y^{16} + (H)Y^{18} + (J)Y^{20}$$

| ASPHÄRE | CURV | K / E | A / F | B / G | C / H | D / J |
|---|---|---|---|---|---|---|
| A( 1) | 0.00046523 | 0.000000 / −3.23697E−28 | −7.36323E−11 / 0.00000E+00 | 1.86189E−15 / 0.00000E+00 | −7.73130E−20 / 0.00000E+00 | 8.54337E−24 / 0.00000E+00 |
| A( 2) | 0.00092527 | −0.000000 / 0.00000E+00 | −5.11521E−11 / 0.00000E+00 | −3.80687E−16 / 0.00000E+00 | −3.05582E−21 / 0.00000E+00 | −7.83597E−27 / 0.00000E+00 |
| A( 3) | 0.00241893 | 0.000301 / 7.76365E−28 | 5.01337E−10 / 0.00000E+00 | 2.76322E−15 / 0.00000E+00 | 1.65053E−19 / 0.00000E+00 | −1.79843E−23 / 0.00000E+00 |
| A( 4) | 0.00112101 | 0.000000 / 2.29050E−25 | 6.42053E−09 / 0.00000E+00 | 6.30201E−15 / 0.00000E+00 | 6.16162E−18 / 0.00000E+00 | −2.15921E−21 / 0.00000E+00 |
| A( 5) | 0.00192607 | 0.000000 / 0.00000E+00 | 1.40503E−10 / 0.00000E+00 | 8.32770E−16 / 0.00000E+00 | 3.64734E−21 / 0.00000E+00 | 5.66305E−26 / 0.00000E+00 |

REFERENZWELLENLÄNGE = 13.4 NM
ABBILDUNGSMASSSTAB = 0.25
BILDSEITIGE APERTUR = 0.23

## Patentansprüche

1. Mikrolithographie-Projektionsobjektiv für kurze Wellenlängen, vorzugsweise ≤ 193 nm mit einer Eintrittspupille und einer Austrittspupille zur Abbildung eines Objektfeldes in ein Bildfeld, das das Segment eines Ringfeldes darstellt, wobei das Segment eine Symmetrieachse und eine Ausdehnung senkrecht zur Symmetrieachse aufweist und die Ausdehnung mindestens 20, bevorzugt 25 mm ist,

   1.1 einem ersten (S1), einem zweiten (S2), einem dritten (S3), einem vierten (S4), einem fünften (S5) und einem sechsten Spiegel (S6) in zentrierter Anordnung zu einer optischen Achse, wobei
   1.2 jeder dieser Spiegel einen Nutzbereich aufweist, in dem die Lichtstrahlen, die durch das Projektionsobjektiv geführt werden, auftreffen
   **dadurch gekennzeichnet, daß**
   1.3 für den Durchmesser des Nutzbereiches des ersten, zweiten, dritten, vierten, fünften und sechsten Spiegels in Abhängigkeit von der numerischen Apertur des Objektives an der Austrittspupille gilt:

Durchmesser des Nutzbereiches ≤ 1200 mm * NA

**2.** Mikrolithographie-Projektionsobjektiv nach Anspruch 1, **dadurch gekennzeichnet, daß**

die numerische Apertur an der Austrittspupille größer als 0,1, bevorzugt größer als 0,2, besonders bevorzugt größer als 0,23, und
der Durchmesser des Nutzbereiches des ersten, zweiten, dritten, vierten, fünften und sechsten Spiegels ≤ 300 mm ist

**3.** Mikrolithographie-Projektionsobjektiv gemäß einem der Ansprüche 1 bis 2, **dadurch gekennzeichnet, daß** der erste, zweite, dritte, vierte, fünfte und sechste Spiegel jeweils einen rückwärtigen Bauraum aufweist, der parallel zur optischen Achse gemessen von der Spiegelvorderseite im Nutzbereich eine Tiefe aufweist, wobei die Tiefe jeweils des ersten, zweiten, dritten, vierten und sechsten Bauraumes mindestens 50 mm und die Tiefe des Bauraumes des fünften Spiegels größer als 1/3 des Wertes des Durchmessers des fünften Spiegels ist, wobei sich die jeweilgen Bauräume nicht durchdringen.

**4.** Mikrolithographie-Projektionsobjektiv gemäß einem der Ansprüche 1 bis 3,
**dadurch gekennzeichnet, daß**
daß alle Bauräume in eine Richtung parallel zur Symmetrieachse ausdehnbar sind, ohne daß der Lichtweg im Objektiv oder der Bauraum eines anderen Spiegels geschnitten wird.

**5.** Mikrolithographie-Projektionsobjektiv gemäß Anspruch 4, **dadurch gekennzeichnet, daß** der erste, zweite, dritte, vierte, fünfte und sechste Spiegel einen Randbereich umlaufend um den Nutzbereich umfasst und der Randbereich mehr als 4 mm beträgt, wobei die Lichtführung im Objektiv obskurationsfrei erfolgt.

**6.** Mikrolithographie-Projektionsobjektiv gemäß einem der Ansprüche 1 bis 4, **dadurch gekennzeichnet, daß** der Nutzbereich des vierten Spiegels geometrisch zwischen zweitem Spiegel und der Bildebene angeordnet ist.

**7.** Mikrolithographie-Projektionsobjektiv gemäß einem der Ansprüche 1 bis 6, **dadurch gekennzeichnet, daß** der vierte Spiegel geometrisch zwischen drittem und zweitem Spiegel angeordnet ist.

**8.** Mikrolithographie-Projektionsobjektiv gemäß einem der Ansprüche 1 bis 6, **dadurch gekennzeichnet, daß** der vierte Spiegel geometrisch zwischen erstem und zweitem Spiegel angeordnet ist.

**9.** Mikrolithographie-Projektionsobjektiv gemäß einem der Ansprüche 1 bis 6, **dadurch gekennzeichnet, daß** der Abstand der Spiegelscheitel entlang der optischen Achse von viertem und erstem Spiegel (S4 S1) zum Abstand von zweitem und erstem Spiegel (S2 S1) im Bereich

$$0,1 < \frac{(S4\ S1)}{(S2\ S1)} < 0,9$$

liegt.

**10.** Mikrolithographie-Projektionsobjektiv gemäß einem der Ansprüche 1 bis 8, **dadurch gekennzeichnet, daß** der Abstand der Spiegelscheitel entlang der optischen Achse von drittem und zweitem Spiegel (S2 S3) zum Abstand von viertem zu drittem Spiegel (S4 S3) im Bereich

$$0,3 < \frac{(S3\ S4)}{(S2\ S3)} < 0,9$$

liegt.

**11.** Mikrolithographie-Projektionsobjektiv gemäß einem der Ansprüche 1 bis 8, **dadurch gekennzeichnet, daß** in Abhängigkeit von der numerischen Apertur NA an der Austrittspupille, dem Abstand der Spiegelscheitel entlang der optischen Achse von fünftem und sechstem Speigel (S5 S6), dem Abstand des Spiegelscheitels des fünften Speigels von der Bildebene (S5 B), dem Krümmungsraidus $r_5$, $r_6$ des fünften und sechsten Spiegels für den mittleren Ringfeldradius R gilt:

$$R \geq \tan\ (\ arc\ \ sin\ \ (\ NA)\ )\ *$$

$$\left[\ (\ S5\ B\ )\ +\ (\ S5\ S6\ )\ -\ \cfrac{1}{\cfrac{2}{r_6}\ -\ \cfrac{1}{r_5\ +\ (\ S5\ S6\ )}}\ \right]$$

**12.** Mikrolithographie-Projektionsobjektiv gemäß einem der Ansprüche 1 bis 11, **dadurch gekennzeichnet, daß** der Einfallswinkel des Hauptstrahles des Feldpunktes, der auf der Symmetrieachse in der Mitte des Objektfeldes liegt auf allen Spiegel < 18° ist.

**13.** Mikrolithographie-Projektionsobjektiv nach einem der Ansprüche 1 bis 12, **dadurch gekennzeichnet, daß** im Projektionsobjektiv in der Lichtrichtung nach dem vierten Spiegel (S4) ein Zwischenbild ausgebildet wird.

**14.** Mikrolithographie-Projektionsobjektiv nach einem der Ansprüche 1 bis 13, **dadurch gekennzeichnet, daß** eine Blende (B) im Lichtweg bzw. Strahlengang auf dem zweiten Spiegel (S2) angeordnet ist.

**15.** Mikrolithographie-Projektionsobjektiv gemäß einem der Ansprüche 1 bis 14, **dadurch gekennzeichnet, daß** der erste Spiegel konvex und der erste, zweite, dritte, vierte, fünfte und sechste Spiegel asphärisch ausgebildet sind.

**16.** Mikrolithographie-Projektionsobjektiv gemäß einem der Ansprüche 1 bis 14, **dadurch gekennzeichnet, daß** der erste Spiegel paraxial flach und der erste, zweite, dritte, vierte, fünfte und sechste Spiegel asphärisch ausgebildet sind.

**17.** Mikrolithographie-Projektionsobjektiv gemäß einem der Ansprüche 1 bis 14, **dadurch gekennzeichnet, daß** der erste Spiegel konkav und der erste, zweite, dritte, vierte, fünfte und sechste Spiegel asphärisch ausgebildet sind.

**18.** Mikrolithographie-Projektionsobjektiv nach einem der Ansprüche 1 bis 17, **dadurch gekennzeichnet, daß** sämtliche Spiegel asphärisch ausgebildet sind.

**19.** Mikrolithographie-Projektionsobjektiv nach einem der Ansprüche 1 bis 17, **dadurch gekennzeichnet, daß** höchstens fünf Spiegel asphärisch sind.

**20.** Mikrolithographie-Projektionsobjektiv nach Anspruch 19, **dadurch gekennzeichnet, daß** der vierte Spiegel sphärisch ausgebildet ist.

**21.** Mikrolithographie-Projektionsobjektiv nach einem der Ansprüche 1 bis 20, **dadurch gekennzeichnet, daß** der zweite bis sechste Spiegel (S2 S6) in der Reihenfolge konkavkonvex - konkav - konvex - konkav ausgebildet ist.

**22.** Mikrolithographie-Projektionsobjektiveinrichtung nach einem der Ansprüche 1 bis 21, **dadurch gekennzeichnet, daß** das Objektiv bildseitig telezentrisch ist.

**23.** Projektionsbelichtungsanlage, **dadurch gekennzeichnet, daß** die Projektionsbelichtungsanlage eine Beleuchtungseinrichtung zur Beleuchtung eines Ringfeldes sowie ein Projektionsobjektiv gemäß einem der Ansprüche 1 bis 22 umfasst.

**24.** Verfahren zur Chipherstellung mit einer Projektionsbelichtungsanlage gemäß Anspruch 23.

**Claims**

**1.** A microlithography projection lens for short wavelengths, preferably ≤ 193 nm, with an entrance pupil and an exit pupil for projecting an object field to an image field representative of the segment of a ring field, with the segment comprising an axis of symmetry and an extension perpendicular to the axis of symmetry and the extension being at least 20 mm, preferably 25 mm;

1.1 with a first (S1), second (S2), third (S3), fourth (S4), fifth (S5) and sixth mirror (S6) in a centric arrangement relative to an optical axis;
1.2 with each of said mirrors having a useful area in which the light beams impinge which are guided through the projection lens,
**characterized in that**
1.3 the following applies for the diameter of the useful area of the first, second, third, fourth, fifth and sixth mirror depending on the numerical aperture of the lens at the exit pupil:

diameter of the useful area $\leq$ 1200 mm * NA

2.  A microlithography projection lens as claimed in claim 1, **characterized in that** the numerical aperture at the exit pupil is higher than 0.1, preferably higher than 0.2, even more preferably higher than 0.23, and the diameter of the useful area of the first, second, third, fourth, fifth and sixth mirror is $\leq$ 300 mm.

3.  A microlithography projection lens as claimed in one of the claims 1 to 2, **characterized in that** the first, second, third, fourth, fifth and sixth mirror each comprises a rearward space which has a depth in the useful area parallel to the optical axis as measured from the front side of the mirror, with the depth of the first, second, third, fourth and sixth space being at least 50 mm and the depth of the space of the fifth mirror being larger than 1/3 of the value of the diameter of the fifth mirror, with the respective spaces not penetrating each other.

4.  A microlithography projection lens as claimed in one of the claims 1 to 3, **characterized in that** all spaces can be extended in a direction parallel to the axis of symmetry without the light path in the lens or the space of another mirror being intersected.

5.  A microlithography projection lens as claimed in claim 4, **characterized in that** the first, second, third, fourth, fifth and sixth mirror comprises a border region encircling the useful area and the border region is more than 4 mm, with the light guidance in the lens occurring in an obscuration-free manner.

6.  A microlithography projection lens as claimed in one of the claims 1 to 4, **characterized in that** the useful area of the fourth mirror is arranged geometrically between the second mirror and the image plane.

7.  A microlithography projection lens as claimed in one of the claims 1 to 6, **characterized in that** the fourth mirror is arranged geometrically between the third and second mirror.

8.  A microlithography projection lens as claimed in one of the claims 1 to 6, **characterized in that** the fourth mirror is arranged geometrically between the first and second mirror.

9.  A microlithography projection lens as claimed in one of the claims 1 to 6, **characterized in that** the distance of the mirror apex along the optical axis from the fourth to first mirror (S4 S1) at a distance from the second to the first mirror (S2 S1) lies in the region of

$$0,1 < \frac{(S4\ S1)}{(S2\ S1)} < 0,9$$

10. A microlithography projection lens as claimed in one of the claims 1 to 8, **characterized in that** the distance of the mirror apex along the optical axis from the third to second mirror (S2 S3) at a distance from the fourth to the third mirror (S4 S3) lies in the region of

$$0,3 < \frac{(S3\ S4)}{(S2\ S3)} < 0,9$$

11. A microlithography projection lens as claimed in one of the claims 1 to 8, **characterized in that** the following applies depending on the numerical aperture NA at the exit pupil, the distance of the mirror apexes along the optical axis from fifth to sixth mirror (S5 S6), the distance of the mirror apex of the fifth mirror from the image plane (S5 B), the radius of curvature $r_5$, $r_6$ of the fifth and sixth mirror for the average ring field radius R:

$$R \geq \tan \; (\text{arc} \; \sin \; (NA)) * $$

$$\left[ (S5\,B) + (S5\,S6) - \frac{1}{\frac{2}{r_6} - \frac{1}{r_5 + (S5\,S6)}} \right]$$

12. A microlithography projection lens as claimed in one of the claims 1 to 11, **characterized in that** the angle of incidence of the principal ray of the field point which lies on the axis of symmetry in the middle of the object field is < 18° in all mirrors.

13. A microlithography projection lens as claimed in one of the claims 1 to 12, **characterized in that** an intermediate image is formed in the projection lens in the direction of the light after the fourth mirror (S4).

14. A microlithography projection lens as claimed in one of the claims 1 to 13, **characterized in that** a diaphragm (B) is arranged in the light path or beam path on the second mirror (S2).

15. A microlithography projection lens as claimed in one of the claims 1 to 14, **characterized in that** the first mirror is convex and the first, second, third, fourth, fifth and six mirror are provided with an aspherical configuration.

16. A microlithography projection lens as claimed in one of the claims 1 to 14, **characterized in that** the first mirror is paraxially flat and the first, second, third, fourth, fifth and six mirror are provided with an aspherical configuration.

17. A microlithography projection lens as claimed in one of the claims 1 to 14, **characterized in that** the first mirror is concave and the first, second, third, fourth, fifth and six mirror are provided with an aspherical configuration.

18. A microlithography projection lens as claimed in one of the claims 1 to 17, **characterized in** all mirrors are provided with an aspherical configuration.

19. A microlithography projection lens as claimed in one of the claims 1 to 17, **characterized in that** not more than five mirrors are provided with an aspherical configuration.

20. A microlithography projection lens as claimed in claim 19, **characterized in that** the fourth mirror is provided with an aspherical configuration.

21. A microlithography projection lens as claimed in one of the claims 1 to 20, **characterized in that** the second to sixth mirror (S2 S6) are arranged in the sequence of concave, convex, concave, convex, concave.

22. A microlithography projection lens device as claimed in one of the claims 1 to 21, **characterized in that** the lens is telecentric on the image side.

23. A projection exposure system, **characterized in that** the projection exposure system comprises an illumination device for illuminating a ring field as well as a projection lens according to one of the claims 1 to 22.

24. A method for producing chips with a projection exposure system according to claim 23.


**Revendications**

1. Objectif de projection destiné à être utilisé en microlithographie pour de courtes longueurs d'onde, de préférence ≤ 193 nm, avec une pupille d'entrée et une pupille de sortie permettant de reproduire un champ objet en un champ image constituant le segment d'un champ annulaire, le segment comportant un axe de symétrie et s'étendant perpendiculairement par rapport à cet axe de symétrie sur une distance d'au moins 20, de préférence de 25 mm,

1.1 avec un premier (S1), un deuxième (S2), un troisième (S3), un quatrième (S4), un cinquième (S5) et un sixième miroir (S6) disposés de manière à être centrés sur un axe optique,

1.2 chacun de ces miroirs comportant une zone utile sur laquelle arrivent les rayons lumineux guidés par l'objectif de projection,

**caractérisé en ce que**

1.3 le diamètre de la zone utile des premier, deuxième, troisième, quatrième, cinquième et sixième miroirs peut être exprimé, en fonction de l'ouverture numérique de l'objectif à la pupille de sortie, comme suit:

$$\text{diamètre de la zone utile} \leq 1200 \text{ mm} * NA.$$

**2.** Objectif de projection destiné à être utilisé en microlithographie selon la revendication 1,
**caractérisé en ce que**
l'ouverture numérique à la pupille de sortie est supérieure à 0,1, de préférence supérieure à 0,2, une préférence toute particulière étant accordée à une ouverture numérique supérieure à 0,23
et
le diamètre de la zone utile des premier, deuxième, troisième, quatrième, cinquième et sixième miroirs étant $\leq 300$ mm.

**3.** Objectif de projection destiné à être utilisé en microlithographie selon l'une quelconque des revendications 1 à 2,
**caractérisé en ce que**
les premier, deuxième, troisième, quatrième, cinquième et sixième miroirs comportent chacun à l'arrière une enceinte de montage d'une profondeur mesurée parallèlement à l'axe optique depuis la face avant du miroir dans la zone utile, chacun des premier, deuxième, troisième, quatrième et sixième miroirs ayant une profondeur d'au moins 50 mm et l'enceinte de montage du cinquième miroir ayant une profondeur supérieure à 1/3 du diamètre du cinquième miroir, les différentes enceintes de montage ne s'interpénétrant pas.

**4.** Objectif de projection destiné à être utilisé en microlithographie selon l'une quelconque des revendications 1 à 3,
**caractérisé en ce que**
toutes les enceintes de montage sont aptes à être agrandies suivant une direction parallèle à l'axe de symétrie sans couper le chemin optique dans l'objectif ou l'enceinte de montage d'un autre miroir.

**5.** Objectif de projection destiné à être utilisé en microlithographie selon la revendication 4,
**caractérisé en ce que**
les premier, deuxième, troisième, quatrième, cinquième et sixième miroirs comprennent une zone en bordure s'étendant sur la périphérie de la zone utile, cette zone en bordure étant supérieure à 4 mm, le guidage de la lumière dans l'objectif s'effectuant sans occultation.

**6.** Objectif de projection destiné à être utilisé en microlithographie selon l'une quelconque des revendications 1 à 4,
**caractérisé en ce que**
la zone utile du quatrième miroir est géométriquement agencée entre le deuxième miroir et le plan image.

**7.** Objectif de projection destiné à être utilisé en microlithographie selon l'une quelconque des revendications 1 à 6,
**caractérisé en ce que**
le quatrième miroir est géométriquement agencé entre le troisième et le deuxième miroir.

**8.** Objectif de projection destiné à être utilisé en microlithographie selon l'une quelconque des revendications 1 à 6,
**caractérisé en ce que**
le quatrième miroir est géométriquement agencé entre le premier et le deuxième miroir.

**9.** Objectif de projection destiné à être utilisé en microlithographie selon l'une quelconque des revendications 1 à 6,
**caractérisé en ce que**
le rapport entre l'écart entre les sommets s'étendant le long de l'axe optique des quatrième et premier miroirs (S4 S1) et l'écart entre le deuxième et le premier miroir (S2 S1) est de l'ordre de

$$0,1 < \frac{(S4\ S1)}{(S2\ S1)} < 0,9$$

**10.** Objectif de projection destiné à être utilisé en microlithographie selon l'une quelconque des revendications 1 à 8, **caractérisé en ce que**
le rapport entre l'écart entre les sommets s'étendant le long de l'axe optique des troisième et deuxième miroirs (S2 S3) et l'écart entre le quatrième et le troisième miroir (S4 S3) est de l'ordre de

$$0,3 < \frac{(S3\,S4)}{(S2\,S3)} < 0,9$$

**11.** Objectif de projection destiné à être utilisé en microlithographie selon l'une quelconque des revendications 1 à 8, **caractérisé en ce qu'**on note

$$R \geq \tan\ (\text{arc}\ \sin\ (NA))\ *$$

$$\left[ (S5\,B) + (S5\,S6) - \cfrac{1}{\cfrac{2}{r_6} - \cfrac{1}{r_5 + (S5\,S6)}} \right]$$

le rayon moyen R du champ annulaire en fonction de l'ouverture numérique NA à la pupille de sortie, de l'écart des sommets s'étendant le long de l'axe optique des cinquième et sixième miroirs (S5 S6), de la distance séparant le sommet du cinquième miroir du plan image (S5 B), du rayon de courbure $r_5$, $r_6$ du cinquième et sixième miroir.

**12.** Objectif de projection destiné à être utilisé en microlithographie selon l'une quelconque des revendications 1 à 11, **caractérisé en ce que**
l'angle d'incidence du rayon principal du point de champ situé sur l'axe de symétrie au centre du champ objet est < 18° sur tous les miroirs.

**13.** Objectif de projection destiné à être utilisé en microlithographie selon l'une quelconque des revendications 1 à 12, **caractérisé en ce que**
l'objectif de projection forme une image intermédiaire après le quatrième miroir (S4) dans le sens de propagation de la lumière.

**14.** Objectif de projection destiné à être utilisé en microlithographie selon l'une quelconque des revendications 1 à 13, **caractérisé en ce qu'**
un diaphragme (B) est disposé sur le deuxième miroir (S2) dans le chemin optique, voire dans le trajet des rayons.

**15.** Objectif de projection destiné à être utilisé en microlithographie selon l'une quelconque des revendications 1 à 14, **caractérisé en ce que**
le premier miroir est convexe et que les premier, deuxième, troisième, quatrième, cinquième et sixième miroirs sont asphériques.

**16.** Objectif de projection destiné à être utilisé en microlithographie selon l'une quelconque des revendications 1 à 14, **caractérisé en ce que**
le premier miroir est paraxial plan et que les premier, deuxième, troisième, quatrième, cinquième et sixième miroirs sont asphériques.

**17.** Objectif de projection destiné à être utilisé en microlithographie selon l'une quelconque des revendications 1 à 14, **caractérisé en ce que**
le premier miroir est concave et que les premier, deuxième, troisième, quatrième, cinquième et sixième miroirs sont asphériques.

**18.** Objectif de projection destiné à être utilisé en microlithographie selon l'une quelconque des revendications 1 à 17, **caractérisé en ce que** tous les miroirs sont asphériques.

**19.** Objectif de projection destiné à être utilisé en microlithographie selon l'une quelconque des revendications 1 à 17, **caractérisé en ce que** cinq miroirs au maximum sont asphériques.

**20.** Objectif de projection destiné à être utilisé en microlithographie selon la revendication 19, **caractérisé en ce que** le quatrième miroir est sphérique.

**21.** Objectif de projection destiné à être utilisé en microlithographie selon l'une quelconque des revendications 1 à 20, **caractérisé en ce que** les miroirs 2 à 6 (S2 S6) sont formés selon la séquence concave - convexe - concave - convexe - concave.

**22.** Objectif de projection destiné à être utilisé en microlithographie selon l'une quelconque des revendications 1 à 21, **caractérisé en ce que** l'objectif est télécentrique sur son côté tourné vers l'image.

**23.** Système d'illumination et de projection, **caractérisé en ce que** le système d'illumination et projection comprend un système d'éclairage destiné à éclairer un champ annulaire et un objectif de projection selon l'une quelconque des revendications 1 à 22.

**24.** Procédé pour réaliser des puces à l'aide d'un système d'illumination et de projection selon la revendication 23.

Fig.1

Fig.2

optische Achse
HA

Fig.3

Fig. 4

Fig.5

Fig.6a

N1

S1

D
145.042 mm

y

x

Fig.6b

N2

S2

y

x

D
157.168 mm

Fig.6c

N3

S3

D
102.367 mm

Fig.6d

N4

S4

D
222.497 mm

## Fig.6e

S5     N5

D
83.548 mm

## Fig.6f

S6

N6

D
270.054 mm

Fig. 7

optische
Achse
HA

208.33 mm

EP 1 178 356 B1

30

Fig.8

Fig.9

EP 1 178 356 B1

Fig.10